Europäisches Patentamt

(19) European Patent Office

Office européen des brevets

(11) Publication number: **0 252 236**
**A2**

# (12) EUROPEAN PATENT APPLICATION

(21) Application number: **87106481.2**

(22) Date of filing: **05.05.87**

(51) Int. Cl.⁴: **H01L 29/78**

(30) Priority: **09.07.86 JP 161601/86**

(43) Date of publication of application:
**13.01.88 Bulletin 88/02**

(84) Designated Contracting States:
**DE FR GB**

(71) Applicant: **Kabushiki Kaisha Toshiba**
**72, Horikawa-cho Saiwai-ku**
**Kawasaki-shi Kanagawa-ken 210(JP)**

(72) Inventor: **Matsunaga, Taira Patent Division**
**Kabushiki Kaisha Toshiba 1-1 Shibaura**
**1-chome**
**Minato-ku Tokyo 105(JP)**
Inventor: **Kimura, Takashi Patent Division**
**Kabushiki Kaisha Toshiba 1-1 Shibaura**
**1-chome**
**Minato-ku Tokyo 105(JP)**
Inventor: **Ishii, Tetsuo Patent Division**
**Kabushiki Kaisha Toshiba 1-1 Shibaura**
**1-chome**
**Minato-ku Tokyo 105(JP)**

(74) Representative: **Lehn, Werner, Dipl.-Ing. et al**
**Hoffmann, Eitle & Partner Patentanwälte**
**Arabellastrasse 4**
**D-8000 München 81(DE)**

(54) **Vertical MOS type semiconductor device.**

(57) A vertical MOS transistor which comprises p type base region (22) formed in n type substrate (21), n type source region (23) formed in the base region (22), and source electrode (28). The base region (22) involves first, second and third regions (22a, 22b, 22c). Channel region (26) is formed on the surface of first region (22a), the source region (23) is formed in second region (22b), third region (22c) contacts source electrode (28), and fourth region (22d) of base region (22) extends from third region (22c) so as to divide the source region and contact the channel region.

# F I G. 5

## Vertical MOS type semiconductor device

This invention relates to a vertical MOS type semiconductor device.

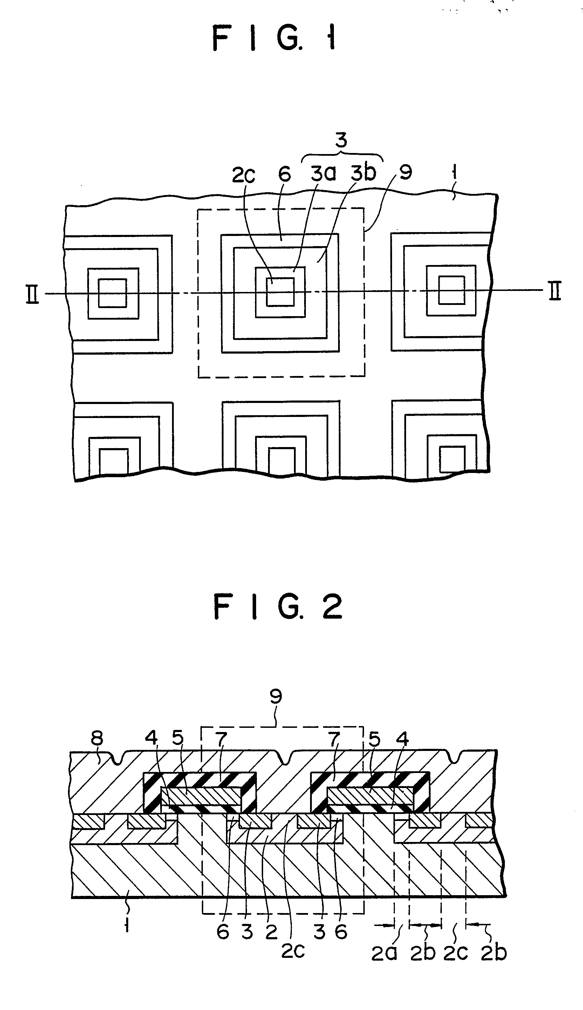

A vertical MOS type semiconductor device is mainly used for switching. In normal operation, a drain current runs through a source electrode, source region, channel region and drain region of the device. In this case, passage resistance to the drain current, namely, $R_{ON}$ has to be minimized. However, the prior art semiconductor device presented difficulties in reducing $R_{ON}$ to a satisfactory extent. Description may now be made of the construction of the conventional vertical MOS transistor with reference to Figs. 1 to 3. Referring to Figs. 1 and 2, p type base region 2 is formed in the surface region of n type silicon substrate 1. n type source region 3 is formed in the surface region of base region 2. Base region 2 comprises first region 2a, second region 2b and third region 2c. Gate insulating layer 4 is provided on that portion of the substrate 1 which intervenes between two adjacent base regions 2, 2. Gate electrode 5 is mounted on gate insulating layer 4. Channel region 6 is formed between the surface of first region 2a and gate insulating layer 4. Source region 3 is formed in second region 2b of base region 2. Gate insulating layer 4 and gate electrode 5 are covered with insulating layer 7. Common source electrode 8 is provided in contact with the surface of third region 2c of base region 2 and part of the surface of source region 3. A region surrounded by dotted lines constitutes unit cell 9. Fig. 1 indicates the pattern of the main surface of substrate 1. Reference numeral 2c denotes the third region contacting electrode 8. Reference numeral 3a represents an area of source region 3 contacting electrode 8. Reference numeral 3b shows the surface area of source region 3, except for area 3a. Reference numeral 6 shows the surface area of channel region.

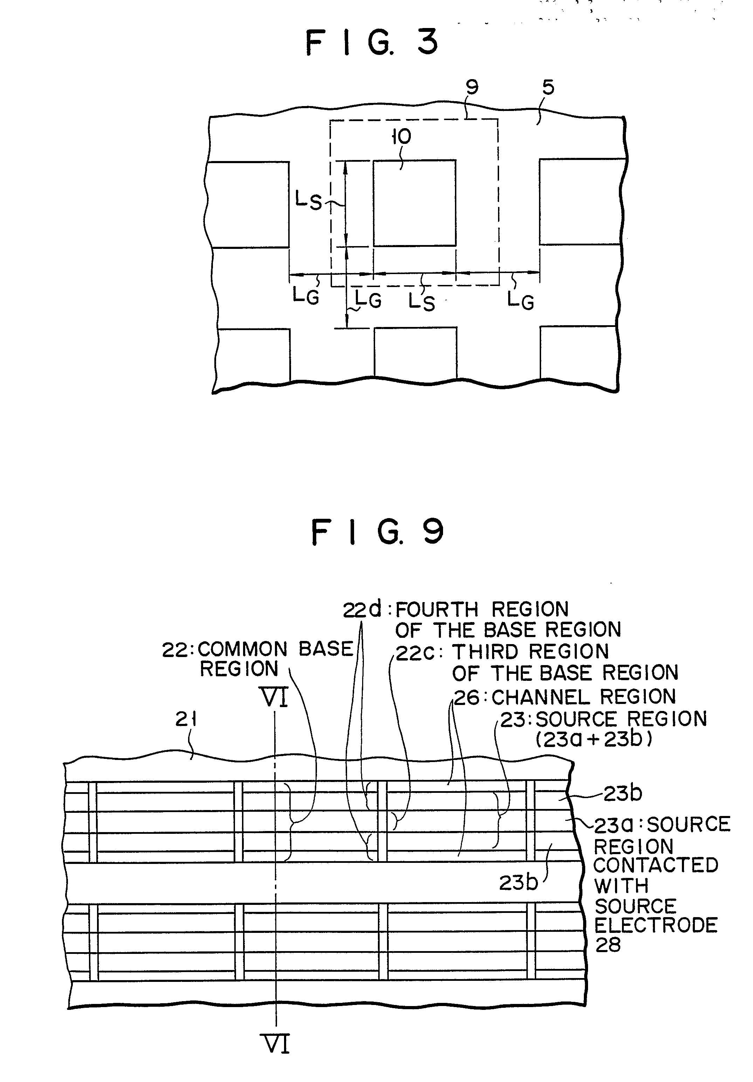

A semiconductor device illustrated in Figs. 1 and 2 is constructed as described below. An insulating layer is formed on substrate 1. A layer for forming gate electrode 5 is deposited on the insulating layer and then patterned to provide gate electrode 5 shown in Fig. 3. Gate electrode 5 comprises a plurality of holes 10 of Ls × Ls (Ls represents a source length). An interval (gate length) of respective holes 10 is denoted by character $L_G$. Gate insulating layer 4 is patterned with gate electrode 5 used as a mask. A p type impurity is diffused through the surface of n type substrate 1 with gate electrode 5 used as a mask, thereby providing base region 2. Later, an n type impurity is diffused with gate electrode 5 again used as a mask, thereby forming source region 3. In this case, channel region 6 is formed with the effective channel length which corresponds to a difference between the depths with which base region 2 and source region 3 are diffused. When source region 3 is formed, n type impurity is not diffused into third region 2c of the base region. Later, insulating layer 7 and source electrode 8 are formed. The surface of third region 2c is brought into contact with source electrode 8. As a result, channel region 6 is grounded through base region 2.

When the MOS transistor device of Fig. 2 is rendered conductive, drain current flows through source electrode 8, source region 3, channel region 6 and drain region 1 (substrate). When the ON resistance (hereinafter referred to as "$R_{ON}$") of the entire above-mentioned passage should be reduced, it is necessary to enlarge the total gate widths of all the cells. Now, let it be assumed that the gate width of each cell corresponds to, for example, the circumferential length of channel region 6 of Fig. 1. If, therefore, it is intended to enlarge the total sum of the channel widths of the cells, it is necessary to minimize the size of the pattern of Fig. 1. In other words, the density of the assembled unit cells has to be increased. If the pattern of gate electrode 5 shown in Fig. 3 is reduced in size, it will be necessary to shorten the gate length $L_G$ and source length $L_S$. Referring to Figs. 1 and 2, third region 2c of base region 2 is intended to cause base region 2 and channel region 6 to be connected to source electrode 8 and ground regions 2 and 6 through source electrode 8. While the semiconductor device of Fig. 2 remains in a normal operating condition, namely, drain current passes through source electrode 8, source region 3, channel region 6, and drain region 1, then second region 2c does not act as a current path. As viewed only from the current path, it would be possible, as naturally expected, to miniaturize the size of the gate electrode pattern shown in Fig. 3 without providing third region 2c. Unless, however, third region 2c is provided, base region 2 and channel region 6 would be electrically set in a floating condition, leading to the occurrence of a parasitic transistor effect. If, therefore, it is intended to let the subject vertical MOS semiconductor device be constructed with a high withstand voltage or be operated with a high frequency, the appearance of the above-mentioned parasitic transistor effect would be objectionable. Consequently, it would be impossible to dispense with third region 2c. If, therefore, it is desired to shorten source

length $L_s$ of Fig. 3, it will be necessary to minimize the area of third region 2c. Moreover, channel region 6 fails to be reliably grounded simply by reducing the area of third region 2c.

The object of this invention is to provide a vertical MOS semiconductor device, which is characterized in that, even when the surface area of the third region of the base region is reduced, the channel region can be reliably grounded; and the resistance to the drain current flowing through the channel region can be decreased.

To attain the above-mentioned object, this invention provides a vertical MOS semiconductor device which comprises: a semiconductor substrate of first conductivity type; a gate insulating layer mounted on a part of the semiconductor substrate, a gate electrode being provided on the gate insulating layer; a base region of second conductivity type formed in a surface region of the semiconductor substrate and comprising first, second and third regions, a channel region being formed between the surface of the first region and the gate insulating layer, a source region of the first conductivity type being formed in the second region, and a source electrode contacting the third region. The base region further comprises a fourth region extending from the third region so as to divide the source region and also contact the channel region.

According to this invention, a third region of the base region, namely, that portion of the base region which contacts the source electrode, extends so as to divide the source region in two and contacts the channel region. If, therefore, the surface area of the third region is made smaller than in the prior art, the channel region can be reliably grounded. Further, the reduced area of the third region makes it possible to miniaturize the pattern of the gate electrode, namely, to increase the density of the assembled unit cells. This means that the total gate width (namely, the total sum of the channel widths of all the unit cells) can be extended, namely, $R_{ON}$ can be decreased.

This invention can be more fully understood from the following detailed description when taken in conjunction with the accompanying drawings, in which:

Fig. 1 is a plan view of the main surface of the semiconductor substrate of the conventional vertical MOS type semiconductor device;

Fig. 2 is a sectional view on line II-II of Fig. 1;

Fig. 3 is a plan view of the gate electrode of Fig. 2;

Fig. 4 is a plan view of the substrate of a semiconductor device according to a first embodiment of the present invention;

Fig. 5 is a sectional view on line V-V of Fig. 4;

Fig. 6 is a sectional view on line VI-VI of Fig. 4;

Fig. 7 is a plan view of the gate electrode of Fig. 5;

Fig. 8 diagramatically shows the relationship between the magnitude of $R_{ON}$ of the semiconductor device of the present invention and that of $R_{ON}$ of the conventional semiconductor device of Fig. 1; and

Fig. 9 is a plan view of the main surface of a semiconductor device according to a second embodiment of the invention.

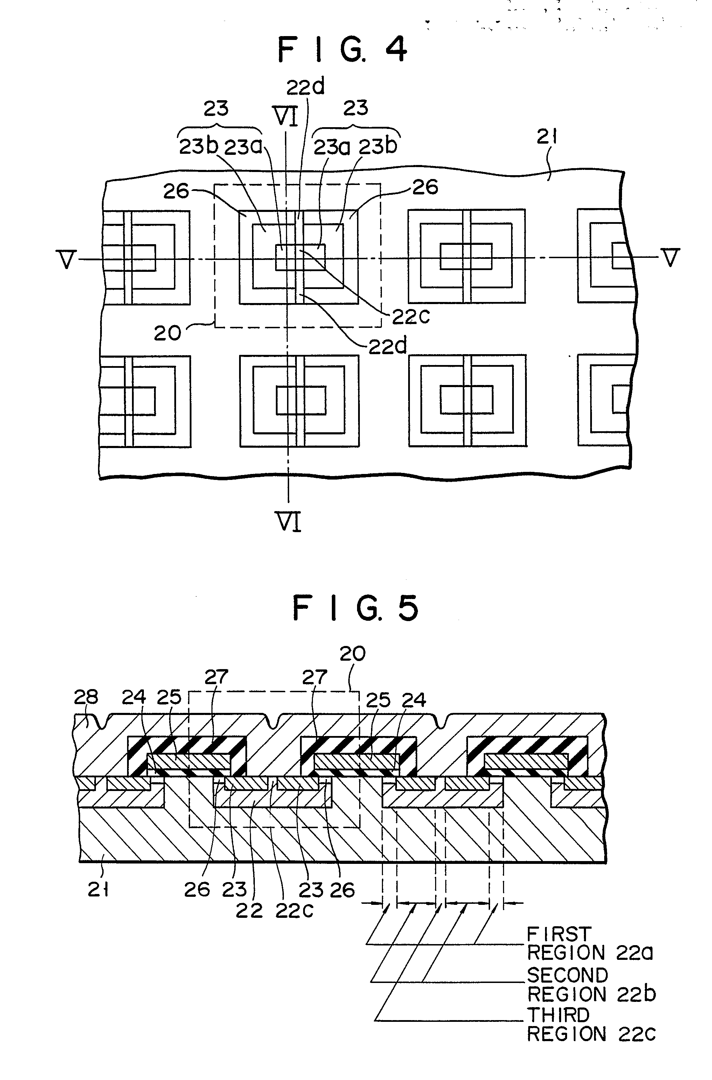

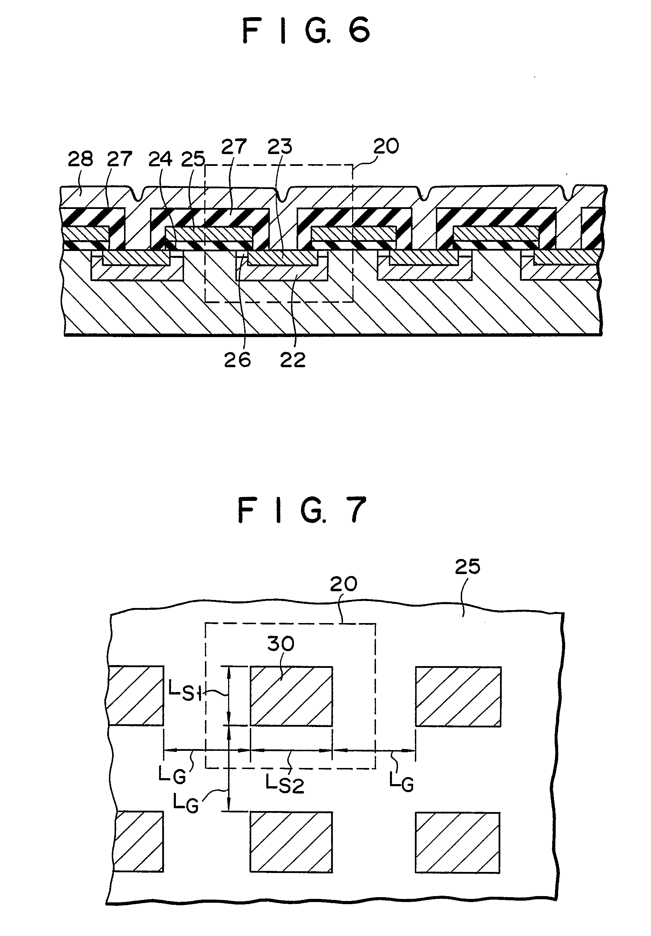

Referring to Figs. 4 and 5, reference numeral 20 represents a unit-cell. A plurality of p type base regions 22 are provided in a matrix form in the surface region of an n type silicon substrate 21. Each base region 22 comprises first region 22a, second region 22b, and third region 22c. Source regions 23, 23 are formed in second region 22b. Gate insulating layer 24 is provided on that portion of the substrate which intervenes between two adjacent base regions 22 so as to bridge the end portions of the corresponding base regions. Gate electrode 25 (Fig. 7) is provided on gate insulating layer 24. Channel region 26 is formed between gate insulation layer 24 and first region 22a of base region 22. Insulating layer 27 covers gate electrode 25. Common source electrode 28 contacts third portion 22c of base region 22 and part of source region 23. Referring to Fig. 4, reference numeral 23a denotes that portion of source region 23 which contacts source electrode 28. Reference numeral 23b represents the portion of source region 23 other than region 23a. Therefore, portions 23a and 23b jointly represent the surface area of source region 23. Referring to Fig. 4, reference numeral 22c denotes the surface area of third region of base region 22 contacting source electrode 28. Two extensions 22d from third region 22c which run parallel to line VI-VI jointly constitute the fourth region of base region 22, and divide source region 23 in two portions and contact channel region 26. Namely, fourth region 22d causes electric contact between third region 22c and source electrode 28 to be connected directly to channel region 26.

The same parts of Fig. 6 as those of Fig. 5 are denoted by the same numerals, description thereof being omitted.

Description may now be made of the method of manufacturing a vertical MOS semiconductor device illustrated in Fig. 5. Substrate 21 is fabricated by growing an epitaxial layer containing phosphorus of $5.5 \times 10^{15}$ cm$^{-3}$ concentration on a wafer containing antimony having a concentration of $3 \times 10^{18}$. The epitaxial layer is positioned on the main surface of substrate 21. An oxide layer is formed on the epitaxial layer with a thickness of 5000 Å. Etching is applied to remove the inside portion other than the predetermined peripheral portion of the oxide layer. A gate oxide layer having a thickness of 1000 Å and a polysilicon layer of 5000 Å are deposited on the portion remaining after the etching of the 5000 Å oxide layer. After subsequent etching, gate oxide layer 24 and gate electrode 25 are provided. The pattern of gate electrode 25 is as illustrated in Fig. 7. Gate electrode 25 is provided with a plurality of holes 30 through which an impurity is to be defused. With gate electrode 25 of Fig. 7 used as a mask, boron ion is implanted at the dose rate of $3 \times 10^{13}$ cm$^{-2}$ and with the acceleration voltage of 40 keV. The implanted boron ions are diffused for 3.5 hours in an $N_2$ gas atmosphere maintained at 1100°C, thereby forming base region 22. Later, with the aid of a resist mask, ansenic ions are implanted at the dose rate of $5 \times 10^{15}$ cm$^{-2}$ with the acceleration voltage of 40 KeV and annealing is applied for 20 minutes in an $N_2$ atmosphere maintained at 1000°C, thereby providing source region 23. At this time, channel region 26 is formed having a channel length which corresponds to a difference between the impurity diffusion depth of base region 22 and the impurity diffusion depth of source region 23. When source region 23 is provided, regions 22c and 22d shown in Fig. 4 are retained thereby to effect a direct connection between source electrode 28 and channel region 26. Later, a phosphorus silicate glass (PSG) layer is deposited with a thickness of 7000 Å over the surface including gate electrode 25 to effect interinsulation layer 25. Contact holes are opened in those portions of the PSG layer which face aforesaid source regions 23. An aluminium layer is deposited on the PSG layer. This aluminium layer is patterned to provide source electrode 28. Fig. 7 represents the pattern of the electrode 25 involved in the semiconductor device of Fig. 5. Reference numerals $L_{S1}$, $L_{S2}$ indicate source lengths, and reference numeral Lg represents a gate length.

As seen from Figs. 4 and 5, third region 22c of base region 22 (a contact area between base region 22 and source electrode 28) is connected to channel region 26 by means of extension 22d (fourth region) from third region 22c of base region 22. Obviously, therefore, it is possible to reduce resistance between third region 22c and channel region 26. Unlike the conventional semiconductor device, the semiconductor device of Fig. 5 representing the present invention has the feature that, even if third region 22c of base region 22 contacting with electrode 28 is reduced in area, the channel region can be reliably grounded. The reduced area of third region 22c makes it possible to decrease the pattern size of the gate electrode, and in consequence, the magnitude of resistance $R_{ON}$.

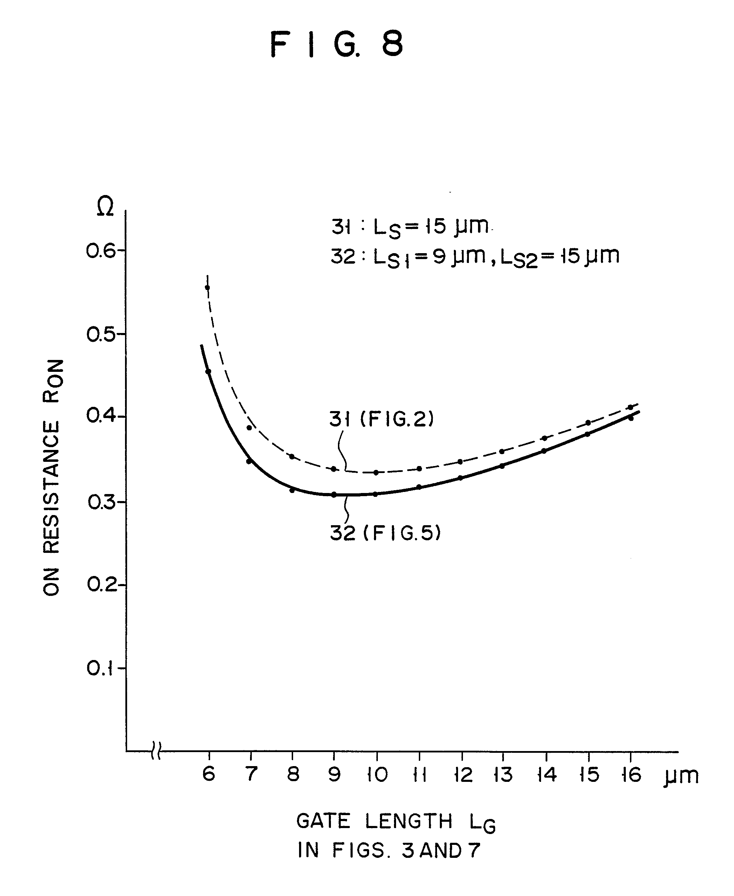

Fig. 8 is a curve diagram showing the property of resistance $R_{ON}$ to gate length Lg. Curve 31 represents the prior art corresponding to Fig. 2. Curve 32 denotes the present invention of Fig. 5. Curves 31, 32 show that $R_{ON}$ changes with Lg (Figs. 3 and 7). Curve 32 [source lengths 9 microns ($L_{S1}$) and 15 microns ($L_{S2}$)] indicates that $R_{ON}$ always has a smaller magnitude than curve 31 (source length 15 microns).

It should be noted that the present invention is not limited to the aforementioned embodiment. Referring to Fig. 4, third region 22c and extension 22d thereof (fourth portion) extend along line VI-VI. However, these portions may be so devised as to extend along line V-V. The present invention is also applicable to a semiconductor device involving stripe-type cells. The sectional view on line VI-VI of Fig. 9 is the same as that of Fig. 6. In Fig. 5, two source regions 23, 23 are formed in base region 22. In contrast, Fig. 9 indicates the device where more than two source regions 23 are provided in common base region 22. The parts the same as those of Fig. 5 are denoted by the same numerals, description thereof being omitted.

## Claims

1. A vertical MOS (metal oxide semiconductor) type semiconductor device which comprises:

a semiconductor substrate (21) of first conductivity type;

a gate insulating layer (24) mounted on a part of said semiconductor substrate, a gate electrode (25) being provided on said gate insulating layer;

a base region (22) of second conductivity type formed in a surface region of said semiconductor substrate and comprising first, second and third regions (22a, 22b, 22c), a channel region (26) being formed between the surface of said first region (22a) and said gate insulating layer, a source region (23) of said first conductivity type being formed in said second region (22b), and a source electrode (28) contacting said third region (22c);

characterized in that said base region (22) further comprises a fourth region (22d) extending from said third region (22c) so as to divide said source region and also contact said channel region (26).

2. A semiconductor device according to claim 1, characterized in that said semiconductor device is provided with a plurality of mesh type cells (20), each having independent base region (22) and two source regions (23, 23) divided by said fourth region (22d) of said base region.

3. A semiconductor device according to claim 1, characterized in that a plurality of stripe type cells are provided, each having a common base region (22), and source regions (23) of more than two which are formed by being divided by said fourth region (22d) of said base region.

# F I G. 1

# F I G. 2

# F I G. 3

# F I G. 9

22d : FOURTH REGION
OF THE BASE REGION

22 : COMMON BASE
REGION

22c : THIRD REGION
OF THE BASE REGION

26 : CHANNEL REGION

23 : SOURCE REGION
(23a + 23b)

23b

23a : SOURCE
REGION
CONTACTED
WITH
SOURCE
ELECTRODE
28

# F I G. 4

# F I G. 5

FIRST REGION 22a
SECOND REGION 22b
THIRD REGION 22c

# F I G. 6

# F I G. 7

# F I G. 8

31 : $L_S = 15 \, \mu m$
32 : $L_{S1} = 9 \, \mu m$, $L_{S2} = 15 \, \mu m$

31 (FIG.2)

32 (FIG.5)

ON RESISTANCE $R_{ON}$

GATE LENGTH $L_G$
IN FIGS. 3 AND 7